# EUROPEAN PATENT APPLICATION

(11) **EP 3 093 991 A1**
(43) Date of publication of application: **16.11.2016**
(21) Application number: 15167352.2
(22) Date of filing: 12.05.2015
(51) Int. Cl.: H03H 9/70

(54) **A FILTER SUBSYSTEM**

(71) Applicant: Services Pétroliers Schlumberger, 75007 Paris (FR); SCHLUMBERGER TECHNOLOGY B.V., 2514 JG Den Haag (NL); Schlumberger Holdings Limited, Road Town, Tortola 1110 (VG)
(72) Inventor: Arun Kumar, Swapna, Sugar Land, TX Texas 77478 (US); Barakat, Simon, 92142 Clamart Cedex (FR)
(74) Representative: Li, Boxi

(57) **Abstract**

A filter subsystem (1) having an analog signal input (2) and a filtered analog signal output (4), one or more input-side components connected in electrical communication with the analog signal input (2) and configured to output an analog electric signal for filtering and one or more output-side components connected in electrical communication with the filtered analog signal output (4) and configured to perform one or more further operations on a filtered analog electric signal. The filter subsystem (1) includes a piezoelectric transformer (3) as a filtering device having a primary side configured to receive the analog electric signal to be filtered and a secondary side configured to output the filtered analog electric signal, and the piezoelectric transformer is configured to filter the analog electric signal to form the filtered analog electric signal, where a filter operation of the piezoelectric transformer is determined by a resonant frequency of a primary vibration mode of the piezoelectric transformer.

## Description

### BACKGROUND

Embodiments of the present disclosure relate to a system for filtering a signal including a filter sub-system using a piezoelectric transformer, along with associated methods and the filter sub-system.

In conventional analog signal processing it is commonly necessary to filter an analog signal prior to further processing and/or conversion into a digital signal.

A common example is in a receiver in which an analog signal is received via an antenna, filtered, amplified, and then passed on to further circuitry for signal detection, digitisation, and/or further transmission or processing for example. Another example is in the handling of signals from sensors.

Analog filtering circuits may comprise, for example, one or more operational amplifiers or other active components which can be arranged, with other active and/or passive circuit components, to achieve a number of different filtering effects. For many analog filtering circuits, the filter requirements mean that a plurality of filter stages is required.

Therefore, conventional analog filtering circuits may comprise a plurality of active circuit components. Inherently, the active circuit components will introduce noise into the analog signal being filtered. The nature of this noise will depend on the specific circuit configuration. It is not uncommon for additional filtering stages to be required in order to attenuate noise generated by preceding filtering stages.

Accordingly, conventional analog filtering circuits can be relatively large and complex.

In downhole conditions, such as a hydrocarbon well, tools are subjected to harsh environment conditions such as high ambient temperatures, shocks and vibrations, humidity *etc.* At the same time, there is a need for a filtering system for wellbore use having a high power transformer design in a small package that can operate in the harsh environment/high temperature.

There is a need, therefore, to provide an analog filter which seeks to ameliorate one or more problems associated with the prior art.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth.

An aspect of the present disclosure provides a filter subsystem that filters an analog signal to produce a filtered analog signal output. The filter subsystem includes a piezoelectric transformer as a filtering device, the piezoelectric transformer having a primary side to receive the analog electric signal to be filtered and a secondary side to output the filtered analog electric signal. The piezoelectric transformer filters the analog electric signal, where a filter operation of the piezoelectric transformer is determined by a resonant frequency of a primary vibration mode of the piezoelectric transformer.

The filter subsystem includes one or more input-side components connected in electrical communication with the analog signal input and configured to output an analog electric signal for filtering and one or more output-side components connected in electrical communication with the filtered analog signal output and configured to perform one or more further operations on a filtered analog electric signal.

The one or more input-side components may include input-side signal conditioning circuitry.

The input-side signal conditioning circuitry may include impedance matching circuitry.

The impedance matching circuitry may include an impedance matching transformer.

The input-side signal conditioning circuitry may include a buffer which is configured to receive an unbuffered analog electric signal and to output the analog electric signal for filtering.

The input-side signal conditioning circuitry may be configured to reduce an amplitude of the analog electric signal for filtering to below a predetermined maximum value and the predetermined maximum value depends on an operating characteristic of the piezoelectric transformer.

The one or more input-side components may include an antenna for use in receiving radio frequency electromagnetic communication signals, wherein the analog electric signal to be filtered is output by the antenna.

The antenna may be a high frequency radio communication antenna.

The one or more input-side components may include a sensor configured to sense one or more parameters and to output the analog electric signal to be filtered, and the analog electric signal to be filtered may correspond with the or each sensed parameter.

The one or more output-side components may include output-side signal conditioning circuitry.

The output-side signal conditioning circuitry may include impedance matching circuitry.

The impedance matching circuitry may include an impedance matching transformer.

The output-side signal conditioning circuitry may include a buffer configured to receive the filtered analog electric signal and to output a buffered filtered analog electric signal. The one or more output-side components may include one or more of a heterodyne receiver, a mixer, a quadrature decoder, and an analog-to-digital converter.

Another aspect provides a filter subsystem for use in a system.

The analog electric signal and the filtered analog electric signal may carry information.

The one or more output-side components may include at least one output-side component which is configured to extract the information from the filtered analog electric signal.

Another aspect provides a method of filtering an analog electric signal by applying the analog electric signal to a primary side of a piezoelectric transformer as a filtering device and outputting a filtered analog electric signal from a secondary side of the piezoelectric transformer to a filtered analog signal output. The piezoelectric transformer filters the analog electric signal to generate the filtered analog electric signal, and a filter operation of the piezoelectric transformer is determined by a resonant frequency of a primary vibration mode of the piezoelectric transformer.

The method may further comprise conditioning the analog electric signal prior to receipt of the analog electric signal at the analog signal input.

The conditioning of the analog electric signal may include amplifying or attenuating the analog electric signal in accordance with one or more operating characteristics of the piezoelectric transformer.

The method may further comprise: conditioning the filtered analog electric signal subsequent to outputting of the filtered analog electric signal from the filtered analog signal output.

The analog electric signal and the filtered analog electric signal may carry information.

The method may further comprise extracting the information from the filtered analog electric signal using one or more output-side components.

Another aspect provides a method of retrofitting a filter subsystem, comprising: providing circuitry including a filter circuit; removing the filter circuit; and replacing the filter circuit with the filter subsystem, wherein the filter subsystem includes a piezoelectric transformer as a filtering device having a primary side configured to receive an analog electric signal to be filtered and a secondary side configured to output a filtered analog electric signal, wherein the piezoelectric transformer is configured to filter the analog electric signal to generate the filtered analog electric signal, and a filter operation of the piezoelectric transformer is determined by a resonant frequency of a primary vibration mode of the piezoelectric transformer.

The method may further comprise: selecting the filter subsystem such that the passband is substantially equal to a passband of the filter circuit.

Another aspect provides a method of building a system by providing one or more input-side components configured to output an analog electric signal; providing one or more output-side components configured to receive a filtered analog electric signal; determining a required filtering characteristic for a filter to generate the filtered analog electric signal from the analog electric signal; and selecting and fitting a filter subsystem including a piezoelectric transformer as a filtering device to achieve the filtering characteristic, the piezoelectric transformer having a primary side configured to receive the analog electric signal to be filtered and a secondary side configured to output the filtered analog electric signal, wherein the piezoelectric transformer is configured to filter the analog electric signal to generate the filtered analog electric signal, and a filter operation of the piezoelectric transformer is determined by a resonant frequency of a primary vibration mode of the piezoelectric transformer.

### BRIEF DESCRIPTION OF THE DRAWINGS

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.
Figure 1 shows a filtering subsystem according to some embodiments;
Figure 2 shows an example configuration of a piezoelectric transformer;
Figure 3 shows a system according to some embodiments;
Figure 4 shows a system according to some embodiments;
Figure 5 shows a system according to some embodiments;
Figure 6 shows a filtering subsystem according to some embodiments; and
Figure 7 shows a filter operation of a filtering subsystem of some embodiments.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

### DETAILED DESCRIPTION

The ensuing description provides preferred exemplary embodiment(s) only, and is not intended to limit the scope, applicability or configuration of the invention. Rather, the ensuing description of the preferred exemplary embodiment(s) will provide those skilled in the art with an enabling description for implementing a preferred exemplary embodiment of the invention. It being understood that various changes may be made in the function and arrangement of elements without departing from the scope of the invention as set forth in the appended claims.

Specific details are given in the following description to provide a thorough understanding of the embodiments. However, it will be understood by one of ordinary skill in the art that the embodiments maybe practiced without these specific details. For example, circuits may be shown in block diagrams in order not to obscure the embodiments in unnecessary detail. In other instances, well-known circuits, processes, algorithms, structures, and techniques may be shown without unnecessary detail in order to avoid obscuring the embodiments.

Also, it is noted that the embodiments may be described as a process which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed, but could have additional steps not included in the figure. A process may correspond to a method, a function, a procedure, a subroutine, a subprogram, etc. When a process corresponds to a function, its termination corresponds to a return of the function to the calling function or the main function.

Moreover, as disclosed herein, the term "storage medium" may represent one or more devices for storing data, including read only memory (ROM), random access memory (RAM), magnetic RAM, core memory, magnetic disk storage mediums, optical storage mediums, flash memory devices and/or other machine readable mediums for storing information. The term "computer-readable medium" includes, but is not limited to portable or fixed storage devices, optical storage devices, wireless channels and various other mediums capable of storing, containing or carrying instruction(s) and/or data. Furthermore, embodiments may be implemented by hardware, software, firmware, middleware, microcode, hardware description languages, or any combination thereof. When implemented in software, firmware, middleware or microcode, the program code or code segments to perform the necessary tasks may be stored in a machine readable medium such as storage medium. A processor(s) may perform the necessary tasks. A code segment may represent a procedure, a function, a subprogram, a program, a routine, a subroutine, a module, a software package, a class, or any combination of instructions, data structures, or program statements. A code segment may be coupled to another code segment or a hardware circuit by passing and/or receiving information, data, arguments, parameters, or memory contents. Information, arguments, parameters, data, etc. may be passed, forwarded, or transmitted via any suitable means including memory sharing, message passing, token passing, network transmission, etc.

It is to be understood that the following disclosure provides many different embodiments, or examples, for implementing different features of various embodiments. Specific examples of components and arrangements are described below to simplify the present disclosure. These are, of course, merely examples and are not intended to be limiting. In addition, the present disclosure may repeat reference numerals and/or letters in the various examples. This repetition is for the purpose of simplicity and clarity and does not in itself dictate a relationship between the various embodiments and/or configurations discussed. Moreover, the formation of a first feature over or on a second feature in the description that follows may include embodiments in which the first and second features are formed in direct contact, and may also include embodiments in which additional features may be formed interposing the first and second features, such that the first and second features may not be in direct contact.

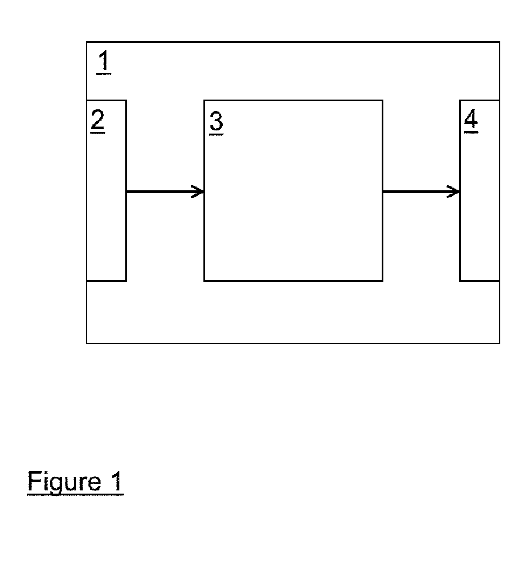

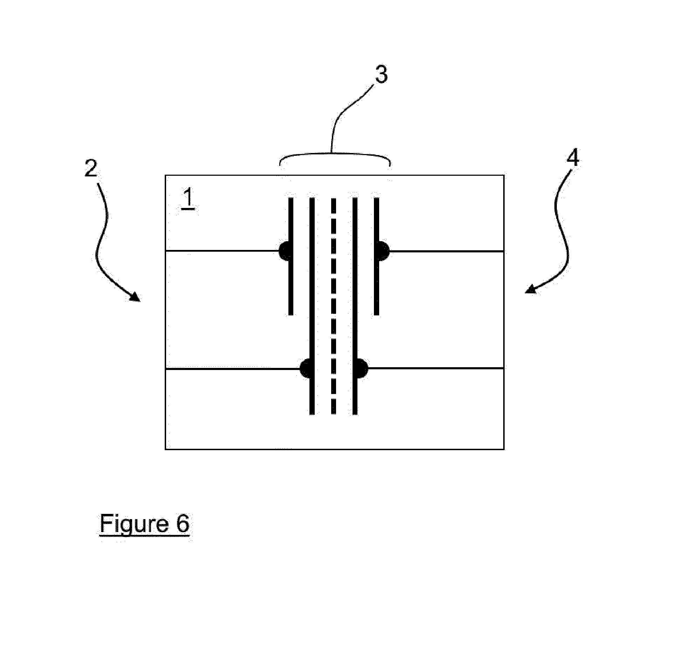

With reference to Figures 1 and 6, some embodiments of the present disclosure comprise a subsystem 1 for filtering a signal (*i.e.* a filter subsystem 1).

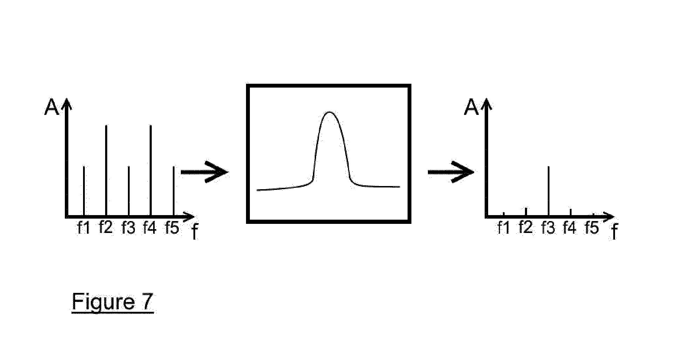

In Fig. 1, the subsystem 1 includes an analog signal input 2, a piezoelectric transformer 3 as a filtering device, and a filtered analog signal output 4. The piezoelectric transformer 3 is configured to receive an analog electric signal for filtering from the analog signal input 2, to perform a filter operation on the analog electric signal, and to output a filtered analog electric signal to the filtered analog signal output 4. The piezoelectric transformer 3 may be configured such that the filter operation is a band-pass filter operation (i.e. the piezoelectric transformer 3 may act as a band-pass filter device). The signal may be amplified in the passband by the piezoelectric transformer 3 (or simply passed without a gain) and may be attenuated in one or more stopbands (i.e. the gain in the passband is higher than the gain in the or each stopband). This is depicted schematically in figure 7, for example.

The piezoelectric transformer 3 of Fig. 1, has been found to be capable of operating at temperatures in excess of 100 degrees centigrade, and even in excess of 150 degrees centigrade and 200 hundred degrees centigrade. As such, the subsystem of Fig. 1 may be used in a downhole tool operated in a hydrocarbon well. Moreover the construction of the piezoelectric transformer 3 provides for operation in humidity, under shock and vibration and the like.

In high temperature testing, it was found that the piezoelectric transformer showed an increase in resonant frequency and an efficiency drop. However, there was no thermal runaway. High temperature terminations were used in the system to mitigate temperature affects and the dependency of resonant frequency on temperature was accounted for in the operation of the system. In the system according embodiments of the present disclosure efficiency drops at high temperature were compensated by using a larger power throughput.

In Fig. 7, the frequency spectrum of the analog electric signal for filtering is shown on the left (i.e. the amplitude of the various frequency components of the signal). That signal is then filtered by the piezoelectric transformer 3 and a depiction of the filtering characteristic (i.e. window/passband) of the piezoelectric transformer 3 is shown centrally. The frequency spectrum of the resulting filtered analog electric signal is shown on the right. As can be seen, the passband encompassed f3 but did not encompass f1, f2, f4, or f5 (which were, accordingly, attenuated).

The passband is determined by the operational characteristics of the piezoelectric transformer 3 and, in particular, the vibration characteristics thereof.

Each piezoelectric transformer 3 which may be used in accordance with embodiments, has a primary vibration mode. Resonance in this primary vibration mode (e.g. the direction of vibration) determines the passband and for which the piezoelectric transformer 3 has been designed. The primary vibration mode may be a thickness vibration mode (i.e. transverse or longitudinal with respect to an electric field in the piezoelectric transformer 3), a radial vibration mode, or a combination of vibration modes (as in a Rosen-type piezoelectric transformer). In embodiments, the primary vibration mode is not a surface acoustic wave and, instead, is a vibration mode through a substantial depth of the piezoelectric material of the piezoelectric transformer 3. Accordingly, the filter operation (e.g. the passband frequency) of the piezoelectric transformer 3 is determined by a resonant frequency of the piezoelectric transformer 3 in the primary vibration mode.

Each piezoelectric transformer 3 will also have one or more secondary vibration modes. The or each secondary vibration mode is a mode of vibration which does not determine the passband but which may result a secondary passband or passbands. These secondary passbands may be undesired and, as discussed herein, embodiments may include components and operations to reduce the effects of such secondary passbands.

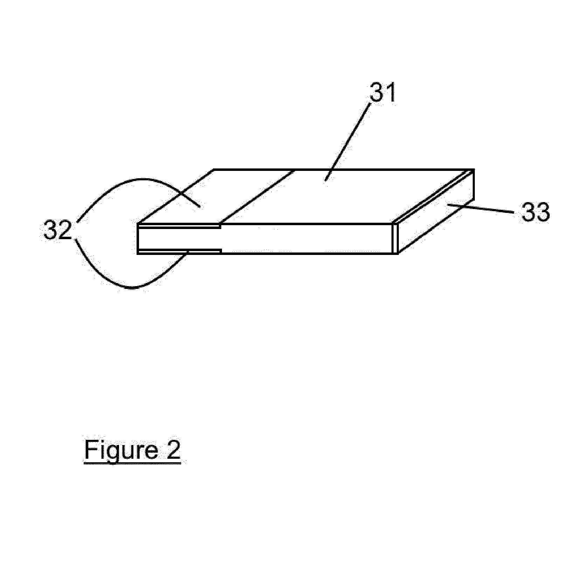

There are several different types of piezoelectric transformer 3 which may be used in accordance with embodiments: for example, Rosen-type devices, thickness vibration mode devices and radial vibration mode devices. As an example of the construction of a piezoelectric transformer, a Rosen-type device is depicted in figure 2.

In Fig. 2, the piezoelectric transformer 3 comprises a piezoelectric material 31, one or more input electrodes 32, and a one or more output electrodes 33 (and a plurality of both input 32 and output 33 electrodes in some embodiments). The configuration of the piezoelectric material 31, input electrodes 32, and output electrodes 33 could take a number of different forms. However, in some examples, the piezoelectric material 31 may comprise a plurality of layers of material. Similarly, the input and output electrodes 32,33 may be arranged in a plurality of layers which may be interleaved with or on opposing sides of the layers of piezoelectric material 31. At least part of the piezoelectric material 31 (e.g. a layer) is, in embodiments, sandwiched between two electrodes of the input electrodes 32 and/or two electrodes of the output electrodes 33.

The input electrodes 32 form part of an input section (or primary side) of the piezoelectric transformer 3 and the output electrodes 33 form part of an output section (or secondary side) of the piezoelectric transformer.

The input electrodes 32 are coupled in electrical communication with the analog signal input 2 and the output electrodes 33 are coupled in electrical communication with the filtered analog signal output 4.

The input electrodes 32 of the piezoelectric transformer 3 are, therefore, configured cause mechanical stress in the piezoelectric material 31 which corresponds with the analog electric signal for filtering which is applied to the input section of the piezoelectric transformer 3. This mechanical stress will, in turn, cause an electrical signal to be generated in the output section of the piezoelectric transformer 3 - the filtered analog electric signal - which is output via the output electrodes 33 and the filtered analog signal output 4.

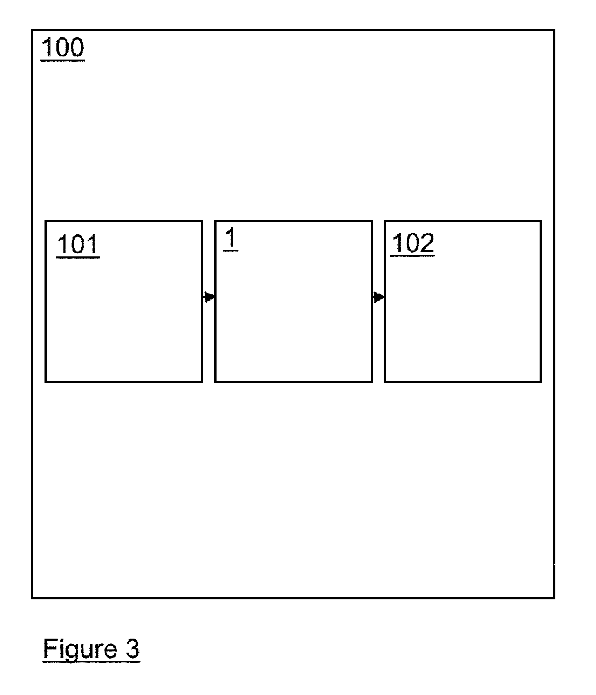

As shown in Fig. 3, the subsystem 1 may be configured for inclusion in a larger system 100 (see figures 3 to 5) which may include other components which are coupled in electrical communication with the analog signal input 2 and/or the filtered analog signal output 4.

The system 100 includes the subsystem 1 and one or more input-side components 101 and one or more output-side components 102.

The form of the input-side and output-side components 101, 102, will depend on the function and purpose of the system 100. Examples are given herein by way of example but it will be appreciated that other examples may form parts of other embodiments. In embodiments, at least one of the output-side components 102 requires the analog electric signal to be filtered before the at least one output-side component 102 can operate on the signal - not filtering the signal may mean that the at least one output side-component 102 would be damaged, would not operate correctly, or would not generate a satisfactory result. The required filtering may include band-pass filtering of the analog electric signal.

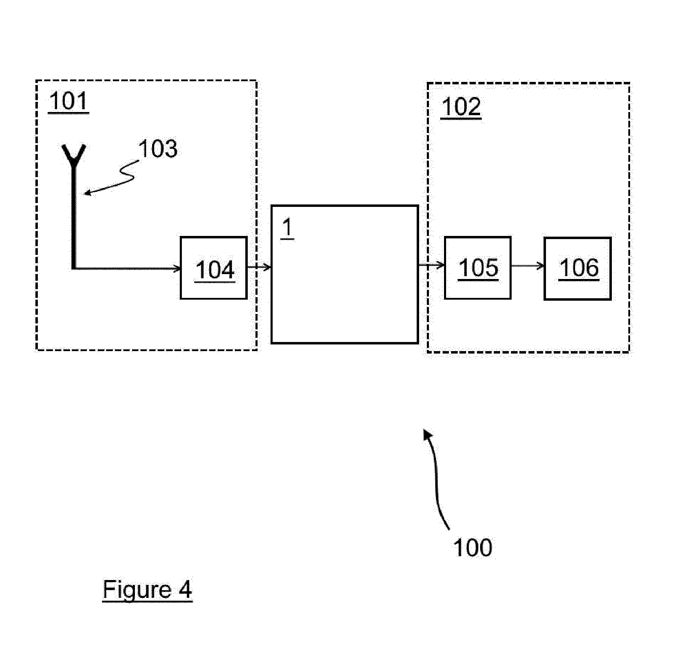

In some examples, as illustrated in Fig. 4, the input-side components 101 may include input-side signal conditioning circuitry 104. The input-side signal conditioning circuitry 104 may be configured to condition the analog electric signal which is to be input via the analog signal input 2. The input-side signal conditioning circuitry 104 may, therefore, be configured to receive an unconditioned analog electric signal, to perform one or more signal conditioning operations, and to output a conditioned analog electric signal as the analog electric signal for filtering.

The or each signal conditioning operation may include one or more of an amplification operation, an attenuation operation, a pre-filtering operation, and an impedance matching operation. In some embodiments, the input-side signal conditioning circuitry 104 may be configured to perform a sequence of signal conditioning operations and this sequence may include more than one amplification and/or pre-filtering and/or attenuation operations, for example.

The input-side signal conditioning circuitry 104 may, therefore, include one or more active and/or one or more passive circuit components. In some embodiments, the input-side signal conditioning circuitry 104 may include a buffer circuit (to receive an unbuffered signal and output a buffered signal), an impedance matching transformer or other circuitry, an amplifier circuit, an attenuation circuit, a filter circuit and/or a tuning circuit.

The input-side signal conditioning circuitry 104 may be configured, in embodiments, to condition the unconditioned analog electric signal such that the amplitude (i.e. voltage) of the signal is below a predetermined maximum amplitude (i.e. voltage) - e.g. using the amplifier and/or attenuation circuits. In some embodiments, the input-side signal conditioning circuitry 104 is configured or further configured to condition the unconditioned analog electric signal such that the amplitude (i.e. voltage) of the signal is above a predetermined minimum amplitude (i.e. voltage) - e.g. using the amplifier and/or attenuation circuits. The predetermined maximum and minimum amplitudes may be determined by the operational characteristics of the piezoelectric transformer 3. Accordingly, the conditioned analog electric signal may have an amplitude which has been conditioned to reduce the likelihood of, or substantially prevent, saturation of the piezoelectric transformer 3 during operation.

The input-side signal conditioning circuitry 104 may be configured to pre-filter the unconditioned analog electric signal such that one or more frequency ranges are attenuated - e.g. using the pre-filter circuit. The one or more frequency ranges may be determined by the operational characteristics of the piezoelectric transformer 3. The one or more frequency ranges may be selected to attenuate the signal at resonant frequencies of secondary vibration modes of the piezoelectric transformer 3, for example. The pre-filtering may assist in reducing the likelihood, or substantially preventing, saturation of the piezoelectric transformer 3 during operation and/or reduce the effects of secondary vibration modes of the piezoelectric transformer 3.

In some embodiments, the input-side signal conditioning circuitry 104 may include the impedance matching transformer or other impedance matching circuitry. This circuitry may be configured to match or substantially match an output impedance of the input-side conditioning circuitry 104 (and/or the input side components 101) with an input impedance of the piezoelectric transformer 3.

In some examples, see figure 4 for example, the input-side components 101 include an antenna 103 which is configured to receive an electromagnetic communication signal - which may be a radio frequency signal and may be a high frequency radio signal - and to convert that electromagnetic communication signal into a corresponding analog electric signal. The antenna 103 may take a number of different forms. In some examples, the electromagnetic communication signal is a short range communication signal (e.g. intended for transmission over a few centimetres, a few metres, or more) and in other examples the electromagnetic communication signal may be a relatively long range communication signal (e.g. intended for transmission over several kilometres or more).

The analog electric signal which is produced at the antenna 103 will include a portion which corresponds with the electromagnetic communication signal but will also include noise and may include a portion which corresponds to one or more other electromagnetic communication signals and/or other interference.

The antenna 103 may be coupled in electrical communication with the analog signal input 2. This coupling may be via one or more further input-side components 101. For example, the input-side signal conditioning circuitry 104 of the input-side components 101 may be connected between the antenna 103 and the analog signal input 2.

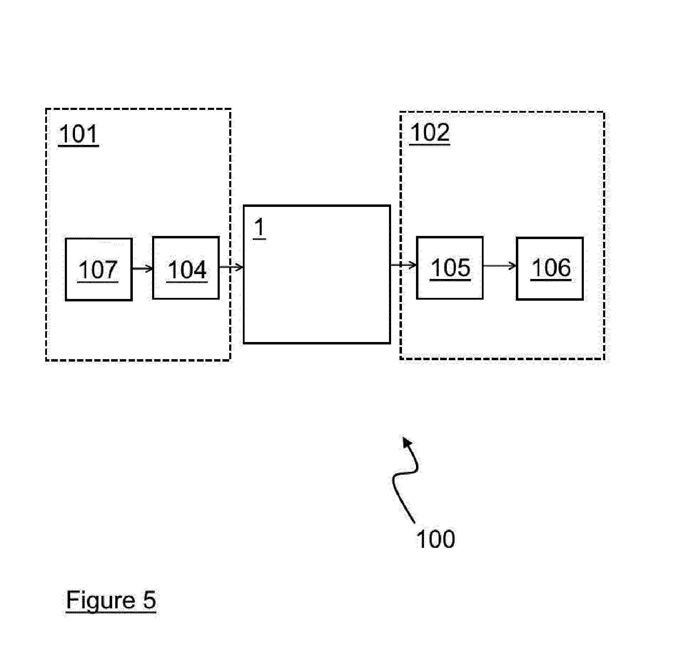

In some examples, see figure 5 for example, the input-side components 101 include a sensor 107 which is configured to sense on or more parameters and to output a corresponding analog electric signal. The sensor 107 may, for example, be a pressure, temperature, movement, seismic, or acceleration sensor, or the like. The sensor 107 may be part of a different system which may, for example, be a system used in drilling a borehole (such as a wellbore), and/or during production of a reservoir (e.g. an oil or gas well), and/or during completion of a wellbore, and/or during intervention in relation to a wellbore.

The output-side components 102 may include output-side signal conditioning circuitry 105. The output-side signal conditioning circuitry 105 may be configured to condition the filtered analog electric signal. The output-side signal conditioning circuitry 105 may, therefore, be configured to receive the filtered analog electric signal from the piezoelectric transformer 3, to perform one or more signal conditioning operations, and to output a conditioned filtered analog electric signal.

The or each signal conditioning operations may include one or more of an amplification operation, an attenuation operation, a post-filtering operation, and an impedance matching operation. In some embodiments, the output-side signal conditioning circuitry 105 may be configured to perform a sequence of signal conditioning operations and this sequence may include more than one amplification and/or post-filtering and/or attenuation operations, for example.

The output-side signal conditioning circuitry 105 may, therefore, include one or more active and/or one or more passive circuit components. In some embodiments, the output-side signal conditioning circuitry 105 may include a buffer circuit (to receive an unbuffered signal and output a buffered signal), an impedance matching transformer or other circuitry, an amplifier circuit, an attenuation circuit, a filter circuit and/or a tuning circuit.

The output-side signal conditioning circuitry 105 may be configured, in embodiments, to condition the filtered analog electric signal such that the amplitude (i.e. voltage) of the signal is below a predetermined maximum amplitude (i.e. voltage) - e.g. using the amplifier and/or attenuation circuits. In some embodiments, the output-side signal conditioning circuitry 105 is configured or further configured to condition the filtered analog electric signal such that the amplitude (i.e. voltage) of the signal is above a predetermined minimum amplitude (i.e. voltage) - e.g. using the amplifier and/or attenuation circuits. The predetermined maximum and minimum amplitudes may be determined by the operational characteristics of one or more of the output-side components 102 and/or the operational characteristics of piezoelectric transformer 3 and/or the operational characteristics of one or more of the input-side components 101. Accordingly, the conditioned filtered analog electric signal may have an amplitude which has been conditioned to allow the correct operation of one or more of the output-side components 102.

The output-side signal conditioning circuitry 105 may be configured to post-filter the filtered analog electric signal such that one or more frequency ranges are attenuated - e.g. using the post-filter circuit. The one or more frequency ranges may be determined by the operational characteristics of the piezoelectric transformer 3. The one or more frequency ranges may be selected to attenuate the signal at resonant frequencies of secondary vibration modes of the piezoelectric transformer 3. The post-filtering may assist in reducing the effects of any artefacts caused by the operation of the piezoelectric transformer 3 as a filter.

In some embodiments, the output-side signal conditioning circuitry 105 may include the impedance matching transformer or other circuitry. This circuitry may be configured to match or substantially match the output impedance of piezoelectric transformer 3 with the input impedance of one or more others of the output-side components 102.

The output-side components 102 may include, for example, one or more of an analog-to-digital converter, a mixer, a quadrature decoder, a heterodyne receiver, and combinations of active and/or passive components. The output-side components 102 may be configured to output a signal to one or more additional components 106 (which may be part of the system 100 or may be part of another system). Such additional components 106 may include one or more processors and the like.

As will be appreciated, and in accordance with Figs. 1 and 6, the piezoelectric transformer 3 may be configured to filter (i.e. attenuate) the signal received through the analog signal input 2 over certain frequencies and to pass and/or amplify the signal over certain other frequencies. These frequencies are determined by the operational characteristics of the piezoelectric transformer 3 and, in particular, by a resonant frequency thereof. This frequency is dependent on the construction of the piezoelectric transformer including the arrangement of the layers of piezoelectric material 31 and the electrodes 32, 33.

The analog electric signal and the filtered analog electric signal may carry information which can be used by the one or more output-side components 102. Accordingly, the one or more output-side components 102 may be configured to extract and/or process the information from the filtered analog electric signal. The information may comprise information from one or more sensors 107 and/or from the electromagnetic communication signal (i.e. a message being communicated using the signal).

The input 32 and output 33 electrodes (and hence the analog signal input 2 and the filtered analog signal output 4) may be galvanically isolated in the piezoelectric transformer 3. Accordingly, galvanic isolation may be provided without the need for additional circuit components.

Compared to conventional filters, embodiments of the disclosure may include fewer components, with fewer interconnections. The reduction in components may reduce the risk of failure and the reduced number of interconnections may reduce the risk of failure of those interconnections (e.g. dry or cracked solder joints).

Embodiments may also help to provide improved sensitivity, sharper cut-off slopes, and a better signal to noise ratio. These advantages may be measured relative to a conventional filter having a corresponding number of stages to embodiments of the disclosure.

As will be appreciated, embodiments may be particularly useful in relation to high frequency signal filtering.

Embodiments of the disclosure include the retrofitting of the subsystem 1 (a piezoelectric filter 3 and/or other components of the subsystem 1) and/or system 100 to existing circuitry. This may include the removal of a conventional filter circuit and replacement with a piezoelectric filter 3 (and/or other components of the subsystem 1 and/or system 100).

Embodiments of the disclosure may also include building a system to provide a filter subsystem 1 between one or more input-side components 101 and one or more output side-components 102. This may include determining a required filtering characteristic for a filter to generate the filtered analog electric signal from the analog electric signal and then selecting and fitting a filter subsystem 1 including a piezoelectric transformer 3 as a filtering device to achieve the filtering characteristic (by a corresponding filter operation). Embodiments of the disclosure include a method of operating the piezoelectric filter 3, including receiving the analog electric signal for filtering, filtering the analog electric signal, and outputting the filtered analog electric signal. In embodiments, the method may further include the conditioning of the analog electric signal and/or the conditioning of the filtered analog electric signal.

As will be understood, embodiments of the system 100 may include electromagnetic communication receivers and transmitters (e.g. radio frequency receivers and transmitted, or high frequency radio receivers and transmitters), sensor systems, and the like.

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. A system comprising:
a filter subsystem having an analog signal input and a filtered analog signal output;
one or more input-side components connected in electrical communication with the analog signal input and configured to output an analog electric signal for filtering; and
one or more output-side components connected in electrical communication with the filtered analog signal output and configured to perform one or more further operations on a filtered analog electric signal, wherein:
the filter subsystem includes a piezoelectric transformer as a filtering device having a primary side configured to receive the analog electric signal to be filtered and a secondary side configured to output the filtered analog electric signal, wherein the piezoelectric transformer is configured to filter the analog electric signal to generate the filtered analog electric signal and a filter operation of the piezoelectric transformer is determined by a resonant frequency of a primary vibration mode of the piezoelectric transformer.

2. A system according to claim 1, wherein:
the one or more input-side components include input-side signal conditioning circuitry, and/or an antenna for use in receiving radio frequency electromagnetic communication signals, wherein the analog electric signal to be filtered is output by the antenna.

3. A system according to claim 2, wherein:
the input-side signal conditioning circuitry includes impedance matching circuitry, or a buffer which is configured to receive an unbuffered analog electric signal and to output the analog electric signal for filtering.

4. A system according to any of claims 2 to 3, wherein:
the input-side signal conditioning circuitry is configured to reduce an amplitude of the analog electric signal for filtering to below a predetermined maximum value and the predetermined maximum value depends on an operating characteristic of the piezoelectric transformer.

5. A system according to any of the preceding claims, wherein:
the one or more input-side components include a sensor configured to sense one or more parameters and to output the analog electric signal to be filtered, and the analog electric signal to be filtered corresponds with the or each sensed parameter.

6. A system according to any preceding claim, wherein:
the one or more output-side components include output-side signal conditioning circuitry, and/or one or more of a heterodyne receiver, a mixer, a quadrature decoder, and an analog-to-digital converter.

7. A system according to claim 8, wherein:
the output-side signal conditioning circuitry includes impedance matching circuitry and/or an impedance matching transformer, or a buffer configured to receive the filtered analog electric signal and to output a buffered filtered analog electric signal.

8. A system according to any of the preceding claims, wherein:
the analog electric signal and the filtered analog electric signal carry information, and
the one or more output-side components include at least one output-side component which is configured to extract the information from the filtered analog electric signal.

9. A downhole tool comprising the system of any of the preceding claims.

10. A method of filtering an analog electric signal, comprising:
receiving the analog electric signal for filtering at an analog signal input;
applying the analog electric signal to a primary side of a piezoelectric transformer as a filtering device; and
outputting a filtered analog electric signal from a secondary side of the piezoelectric transformer to a filtered analog signal output, wherein the piezoelectric transformer is configured to filter the analog electric signal to generate the filtered analog electric signal, and a filter operation of the piezoelectric transformer is determined by a resonant frequency of a primary vibration mode of the piezoelectric transformer.

11. A method according to claim 10, further comprising:
conditioning the analog electric signal prior to receipt of the analog electric signal at the analog signal input, wherein the conditioning of the analog electric signal includes amplifying or attenuating the analog electric signal in accordance with one or more operating characteristics of the piezoelectric transformer.

12. A method according to any of claims 10 or 11, further comprising:
conditioning the filtered analog electric signal subsequent to outputting of the filtered analog electric signal from the filtered analog signal output.

13. A method according to any of claims 10, 11 or 12, further comprising:
operating the piezoelectric transformer at a temperature in excess of 100 degrees centigrade.

14. A method of retrofitting a filter subsystem, comprising:
providing circuitry including a filter circuit;
removing the filter circuit; and
replacing the filter circuit with the filter subsystem, wherein the filter subsystem includes a piezoelectric transformer as a filtering device having a primary side configured to receive an analog electric signal to be filtered and a secondary side configured to output a filtered analog electric signal, wherein the piezoelectric transformer is configured to filter the analog electric signal to generate the filtered analog electric signal, and a filter operation of the piezoelectric transformer is determined by a resonant frequency of a primary vibration mode of the piezoelectric transformer.

15. A method according to claim 14, further comprising:
selecting the filter subsystem such that the passband is substantially equal to a passband of the filter circuit.

16. A method of building a system, comprising:
providing one or more input-side components configured to output an analog electric signal;
providing one or more output-side components configured to receive a filtered analog electric signal;
determining a required filtering characteristic for a filter to generate the filtered analog electric signal from the analog electric signal; and
selecting and fitting a filter subsystem including a piezoelectric transformer as a filtering device to achieve the filtering characteristic, the piezoelectric transformer having a primary side configured to receive the analog electric signal to be filtered and a secondary side configured to output the filtered analog electric signal, wherein the piezoelectric transformer is configured to filter the analog electric signal to generate the filtered analog electric signal, and a filter operation of the piezoelectric transformer is determined by a resonant frequency of a primary vibration mode of the piezoelectric transformer.
